# DEMANDE DE BREVET EUROPEEN

(11) **EP 0 999 585 A1**
(43) Date de publication de la demande: **10.05.2000**
(21) Numéro de dépôt: 99410149.1
(22) Date de dépôt: 03.11.1999
(51) Int. Cl.: H01L 21/8242, H01L 27/108

(54) **Fabrication de mémoire dram et de transistors mos**

(30) Priorité: 05.11.1998 FR 9814091
(71) Demandeur: STMicroelectronics SA, 94250 Gentilly Cedex (FR); FRANCE TELECOM, 75015 Paris (FR)
(72) Inventeur: Ciavatti, Jérôme, 38400 Saint Martin D'Heres (FR)
(74) Mandataire: de Beaumont, Michel

(57) **Abrégé**

L'invention concerne un procédé de fabrication de cellules DRAM dans un substrat (1) comprenant les étapes suivantes : déposer un premier conducteur (6) dans des premières ouvertures dans un premier isolant (5) exposant partiellement des régions (2, 3) de source/drain des transistors de commande ; ouvrir dans un deuxième isolant (7) de façon à exposer partiellement les premières ouvertures contactant les régions de source/drain (2), déposer un deuxième conducteur (8), puis un troisième isolant (9), délimiter dans les troisième isolant et deuxième conducteur des lignes de bit des cellules mémoire, et former des espaceurs latéraux (10) sur les côtés des lignes de bit ; ouvrir un quatrième isolant (11) de façon à exposer partiellement les premières ouvertures en contact avec les régions de drain/source (3) des transistors ; déposer et graver un troisième conducteur (12) ; déposer de façon conforme un diélectrique (13) ; et déposer un troisième conducteur (14).

## Description

La présente invention concerne la fabrication sous forme monolithique de cellules mémoire dynamique à accès aléatoire (DRAM). Plus particulièrement, la présente invention concerne la fabrication sur une même tranche semiconductrice de cellules mémoire DRAM et de transistors MOS selon un procédé compatible avec un procédé CMOS standard.

La présente invention vise à proposer un nouveau procédé de fabrication simultanée de cellules DRAM et de transistors MOS dans un même circuit intégré qui soit relativement simple.

La présente invention vise également à proposer un tel procédé qui permette d'augmenter la densité de cellules mémoire DRAM.

Pour ce faire la présente invention prévoit un procédé de fabrication de cellules mémoire dynamique à accès aléatoire dans un substrat semiconducteur comportant chacune un transistor MOS de commande et un condensateur, caractérisé en ce qu'il comprend les étapes suivantes :
a) former dans une première couche isolante des premières ouvertures de façon à exposer partiellement des régions de source/drain des transistors de commande et remplir les premières ouvertures d'un premier matériau conducteur ;
b) déposer une deuxième couche isolante, former dans celle-ci des deuxièmes ouvertures, de façon à exposer partiellement les premières ouvertures en contact avec les régions de source/drain des transistors, déposer successivement un deuxième matériau conducteur, puis une troisième couche isolante, délimiter dans la troisième couche isolante et le deuxième matériau conducteur des structures de lignes de bit des cellules mémoire, et former des espaceurs latéraux sur les côtés des lignes de bit ;
c) déposer une quatrième couche isolante ;
d) former dans la quatrième couche isolante des troisièmes ouvertures, de façon à exposer partiellement les premières ouvertures en contact avec les régions de drain/source des transistors ;
e) déposer et graver un troisième matériau conducteur, de façon à recouvrir les parois et le fond des troisièmes ouvertures, constituant une première électrode du condensateur ;
f) déposer de façon conforme un matériau diélectrique constituant un isolant du condensateur ; et
g) déposer un troisième matériau conducteur constituant une deuxième électrode du condensateur.

Selon un mode de réalisation, avant l'étape b) de dépôt de la deuxième couche isolante et de formation des structures de ligne de bits, sont formées des vignettes isolantes au-dessus des premières ouvertures contactant les régions de source/drain des transistors de commande.

Selon un mode de réalisation, l'étape c) de dépôt de la quatrième couche isolante est effectuée de façon que sa surface supérieure soit sensiblement plane.

Selon un mode de réalisation, la première couche isolante est un multicouche.

Selon un mode de réalisation, les couches inférieure et supérieure du multicouche constituant la première couche isolante sont respectivement en des premier et deuxième matériaux isolants gravables sélectivement l'un par rapport à l'autre.

Selon un mode de réalisation, la deuxième couche isolante est un multicouche.

Selon un mode de réalisation, les couches supérieure et inférieure du multicouche constituant la deuxième couche isolante sont respectivement en des premier et deuxième matériaux isolants gravables sélectivement l'un par rapport à l'autre.

Selon un mode de réalisation, les vignettes isolantes sont formées par le dépôt d'une couche en un premier matériau isolant.

Selon un mode de réalisation, les vignettes isolantes sont formées par le dépôt d'un multicouche dont la couche supérieure est en un premier matériau isolant.

Selon un mode de réalisation, l'étape a) de formation et de remplissage des premières ouvertures est également effectuée dans une deuxième partie du substrat de façon à exposer partiellement et contacter des régions semiconductrices.

Selon un mode de réalisation, les vignettes isolantes sont formées simultanément au-dessus des premières ouvertures contactant les régions de source/drain des transistors de commande et des premières ouvertures contactant les régions semiconductrices.

Selon un mode de réalisation, la troisième couche isolante, ainsi que les espaceurs sont en un premier matériau isolant.

Selon un mode de réalisation, les quatrième et cinquième couches isolantes sont en un deuxième matériau isolant.

Selon un mode de réalisation, le premier matériau isolant est du nitrure de silicium et le deuxième matériau isolant est de l'oxyde de silicium.

Ces objets, caractéristiques et avantages, ainsi que d'autres de la présente invention seront exposés en détail dans la description suivante de modes de mise en oeuvre particuliers faite à titre non-limitatif en relation avec les figures jointes parmi lesquelles :
les figures 1 à 6 sont des vues en coupe d'une même plaquette de circuits intégrés à différentes étapes successives de sa fabrication selon un mode de mise en oeuvre de la présente invention ; et
la figure 7 est une vue en coupe d'une plaquette de circuits intégrés à une étape de sa fabrication correspondant à celle illustrée en figure 6, obtenue selon un autre mode de mise en oeuvre de la présente invention.

Par souci de clarté, les mêmes éléments ont été désignés par les mêmes références aux différentes figures et, de plus, comme cela est habituel dans la représentation des circuits intégrés, les différentes vues en coupe ne sont pas tracées à l'échelle.

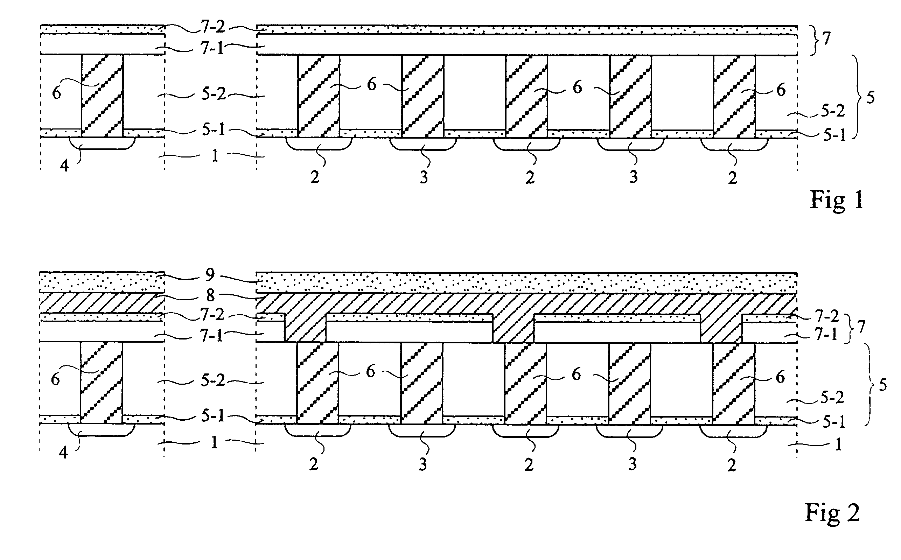

Un premier mode de mise en oeuvre de la présente invention sera exposé ci-après en relation avec les figures 1 à 6.

On veut former, à droite des figures, sur une première partie d'un substrat semiconducteur 1, typiquement en silicium, des cellules mémoire DRAM dont chacune est constituée d'un transistor MOS de commande et d'un condensateur, une première électrode du condensateur étant en contact avec la région de drain/source du transistor. Sur une deuxième partie du substrat 1, à gauche des figures, on désire former des circuits logiques, comportant des transistors MOS. Ci-après les première et deuxième parties seront appelées respectivement côté mémoire et côté logique. On notera que par "substrat" on désigne tant le substrat lui-même que des caissons et/ou régions dopés formés dans celui-ci. On supposera ci-après que, côté mémoire et côté logique, des structures de transistors MOS et de transistors de commande des cellules mémoire ont déjà été formées dans le substrat et ces structures ne sont pas représentées aux figures.

Plus particulièrement, côté mémoire, on veut former des lignes de bit en contact avec une région de source/drain 2 des transistors de commande, et un condensateur ayant une première électrode en contact avec une région de drain/source 3 des transistors de commande. Côté logique, on veut former des contacts avec des régions semiconductrices de drain ou de source 4 également formées dans le substrat 1. Ces dernières reprises de contact, côté logique, devront chacune rejoindre une ligne d'interconnexion métallique située à une altitude donnée au-dessus du substrat, fixée par les contraintes d'un procédé CMOS standard, comprise par exemple entre 0,6 et 2 µm, couramment de l'ordre de 1 µm.

On commence par déposer, côté logique et côté mémoire, une première couche isolante 5 de façon que sa surface supérieure soit sensiblement plane. Selon un mode de réalisation particulier, la couche 5 sera un multicouche constitué de matériaux gravables sélectivement l'un par rapport à l'autre. Par exemple, il s'agira d'une couche mince 5-1 de nitrure de silicium (Si₃N₄) et d'une couche épaisse 5-2 d'oxyde de silicium (SiO₂).

Selon l'invention, à l'aide d'un même masque, on forme alors dans la couche isolante 5 des premières ouvertures de mêmes dimensions, afin d'exposer côté mémoire les régions de source/drain 2 et 3 et côté logique les régions de source ou de drain 4.

On dépose et on grave alors un premier matériau conducteur 6, par exemple du silicium polycristallin ou du tungstène, afin de remplir les premières ouvertures.

Les séquences d'étapes qui vont être décrites ci-après en relation avec les figures 2 à 5 sont essentiellement destinées à réaliser côté mémoire une structure désirée.

On dépose une deuxième couche isolante 7 de façon que sa surface supérieure soit sensiblement plane. Selon le mode de réalisation particulier représenté en figure 1, la deuxième couche isolante 7 est un multicouche constitué de deux matériaux gravables sélectivement l'un par rapport à l'autre. Par exemple, il s'agira d'une couche 7-1 de même nature que la première couche isolante 5, en oxyde de silicium, et d'une couche 7-2 de nitrure de silicium.

Selon des variantes non représentées, la deuxième couche isolante 7 pourra également être une couche unique d'oxyde de silicium ou une couche unique de nitrure de silicium. Toutefois, l'utilisation d'un multicouche 7-1/7-2 sera préférée pour des raisons qui seront exposées ci-après.

Comme l'illustre la figure 2, aux étapes suivantes, on forme dans la deuxième couche isolante 7 des deuxièmes ouvertures de façon à exposer partiellement la surface supérieure de celles des premières ouvertures qui contactent les régions de source/drain 2 des transistors de commande des cellules mémoire.

Ces deuxièmes ouvertures sont ensuite remplies en déposant un deuxième matériau conducteur 8, par exemple, du tungstène déposé de façon conforme, ou du titane/nitrure de titane. On dépose ensuite de façon conforme une troisième couche isolante 9, par exemple en nitrure de silicium.

On notera que, selon les modes de mise en oeuvre représentés aux figures 2 à 6 et 7, on suppose que l'épaisseur de la couche 8 est suffisante pour remplir complètement les deuxièmes ouvertures. En pratique, ce pourrait ne pas être le cas, et la surface supérieure de la troisième couche isolante 9 pourrait présenter des évidements correspondants sans incidence particulière sur le reste du procédé.

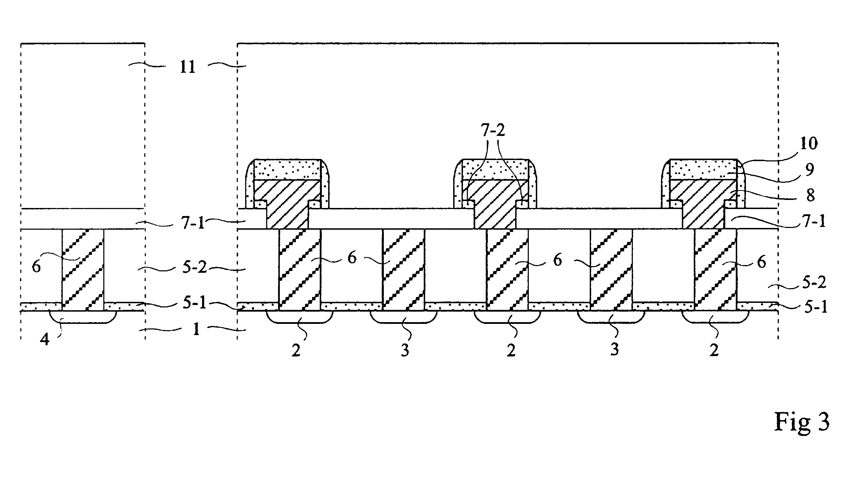

Aux étapes suivantes, illustrées en figure 3, les couches isolante 9, conductrice 8 et isolante 7-2 sont gravées de façon à former au-dessus des deuxièmes ouvertures remplies par le deuxième matériau 8 des structures de lignes de bit. Les lignes de bit sont constituées d'éléments du matériau conducteur 8 en contact électrique avec les sources/drains 2, par l'intermédiaire du conducteur 6. On forme alors sur les côtés des éléments 8 des espaceurs 10, par exemple en nitrure de silicium. Ainsi, les lignes conductrices 8 sont protégées de tout côté par une couche de nitrure de silicium, en haut la couche 9, en bas la couche 7-2, et latéralement les espaceurs 10. On dépose ensuite une quatrième couche isolante 11, de même nature que la couche isolante 7-1, par exemple en oxyde de silicium. Selon un mode de réalisation particulier, la couche 11 peut alors être planarisée.

Du côté logique, après ces étapes, seules les couches 7-1 et 11 sont conservées.

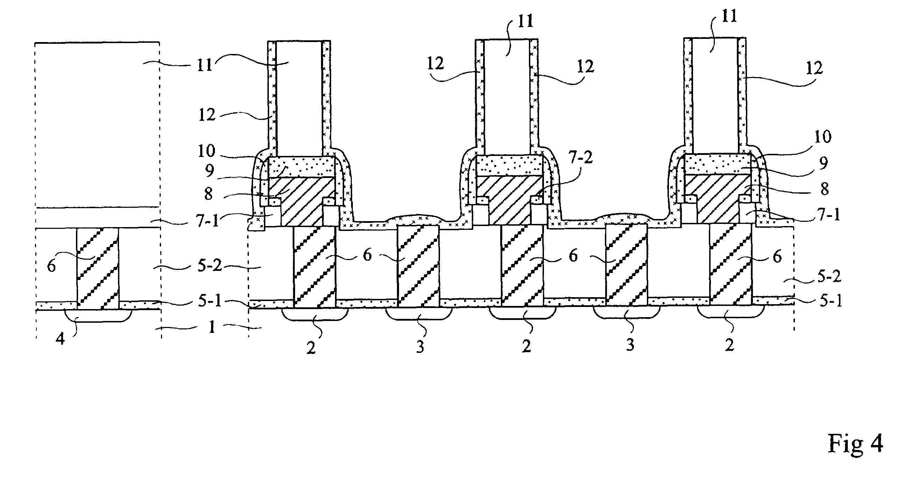

Ensuite, comme l'illustre la figure 4, on élimine, côté mémoire, la quatrième couche isolante 11 de façon à ne la conserver qu'au-dessus d'une partie de chacune des lignes de bit 8. On élimine également la couche 7-1. On forme ainsi des troisièmes ouvertures exposant notamment les surfaces supérieures et éventuellement les flancs des premiers conducteurs 6 en contact avec les régions de drain/source 3. Alors, on dépose un troisième matériau conducteur 12, par exemple en silicium polycristallin, de façon à recouvrir les parois et le fond des troisièmes ouvertures. Le troisième matériau conducteur 12 est ensuite gravé par tout moyen connu pour éliminer les parties du troisième matériau conducteur 12 formées au-dessus de la couche isolante 11.

On notera que la quatrième couche isolante 11 et les couches 7-1 et 5-2 étant en un même premier matériau isolant (oxyde de silicium), leur gravure peut avantageusement être effectuée selon un même procédé. On aura alors une surgravure latérale limitée de la couche 7-1 sous les structures de ligne de bit. La surgravure de la première couche isolante 5-2 peut être accentuée volontairement afin d'augmenter la capacité du condensateur en cours de formation.

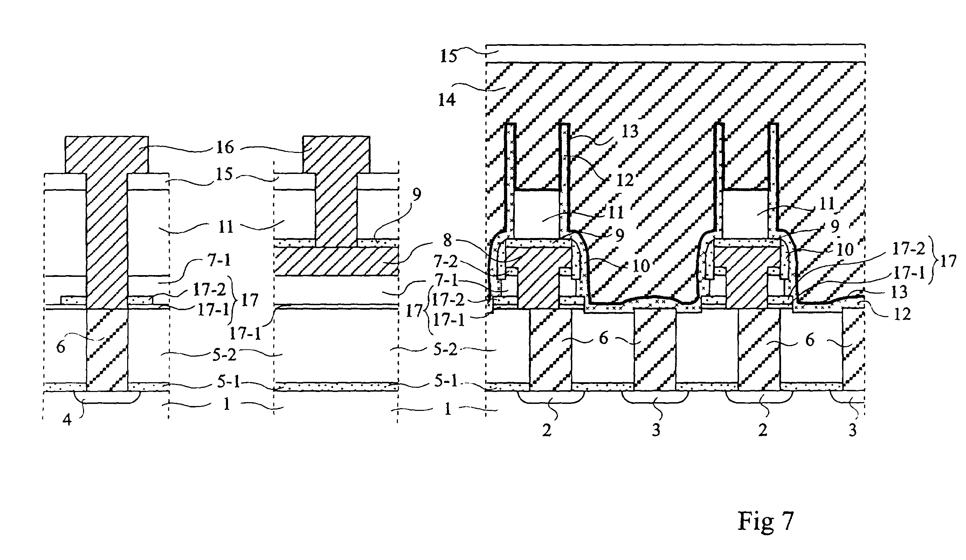

La troisième couche isolante 9, les espaceurs 10 et les résidus de la couche 7-2 étant en un même deuxième matériau (nitrure de silicium) gravable sélectivement par rapport au premier matériau isolant, constituent des couches d'arrêt de gravure qui protègent les lignes de bit. Le conducteur 12 déposé ultérieurement ne risque donc pas de venir en contact avec la ligne de bit, que ce soit par le haut, par le bas ou par les côtés. Selon un mode de réalisation qui sera décrit ci-après en relation avec la figure 7, une protection supplémentaire contre les courts circuits peut être prévue entre le conducteur 12 et le conducteur 6 de contact entre les lignes de bit 8 et les régions de source/drain 2.

Du côté logique, après ces étapes, seule reste en place la couche 11.

Selon la présente invention, les résidus de la quatrième couche isolante 11 peuvent alors être ou non gravés partiellement ou éliminés complètement côté mémoire.

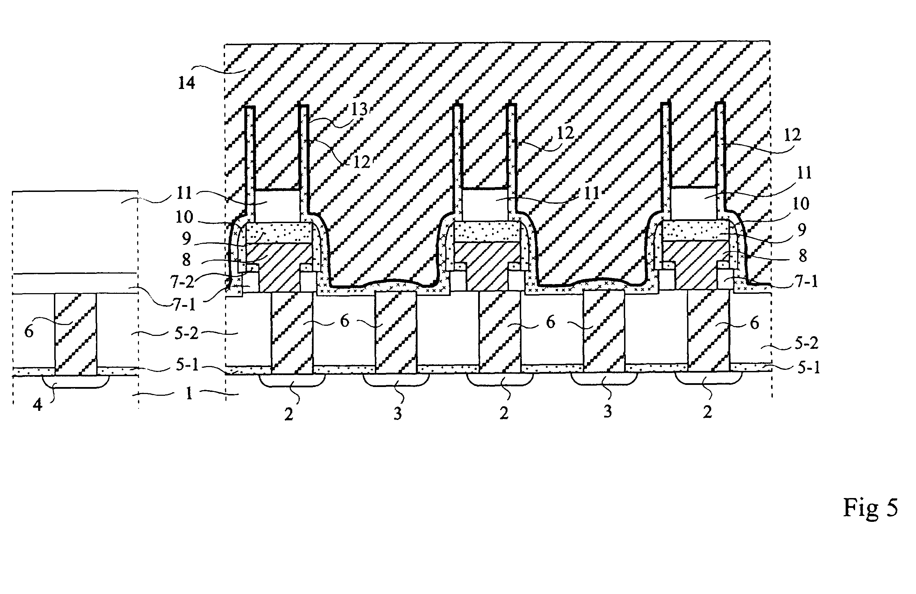

La figure 5 illustre un mode de réalisation particulier de l'invention selon lequel une partie de la couche 11 a été partiellement éliminée. Cette élimination s'effectue côté mémoire et côté logique.

Aux étapes suivantes, également illustrées en figure 5, on dépose une couche mince d'un matériau diélectrique 13, par exemple de l'oxyde de tantale (Ta₂0₅) ou un multicouche oxyde de silicium - nitrure de silicium - oxyde de silicium (ONO). On dépose ensuite un quatrième matériau conducteur 14, par exemple du silicium polycristallin. Le conducteur 14 est déposé et gravé de façon à remplir complètement les troisièmes ouvertures et de façon que sa surface supérieure soit sensiblement plane. Selon une variante non représentée, le quatrième matériau conducteur pourra être du nitrure de titane. Alors les troisièmes ouvertures ne seront pas remplies complètement.

On a ainsi formé côté mémoire des condensateurs comportant chacun une première électrode en forme de U constituée du troisième matériau conducteur 12, un diélectrique constitué du matériau isolant 13 et une seconde électrode commune constituée du quatrième matériau conducteur 14. Chacune des premières électrodes 12 est en contact électrique avec une région de drain/source 3 par l'intermédiaire du conducteur 6. Du côté logique, après ces étapes, seule reste en place la couche 11, partiellement gravée.

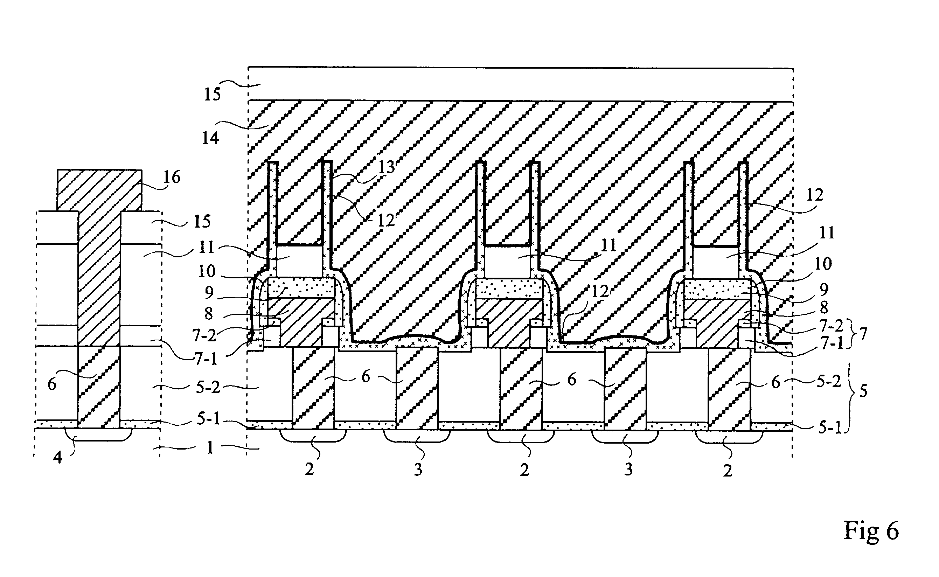

Aux étapes suivantes, illustrées en figure 6, on dépose, de façon conforme, côté logique et côté mémoire, une cinquième couche isolante 15, par exemple en oxyde de silicium. On forme ensuite dans la couche 15 des quatrièmes ouvertures de façon à exposer côté logique les surfaces remplies des premières ouvertures en contact avec les régions de source ou de drain 4. Ces quatrièmes ouvertures sont remplies d'un cinquième matériau conducteur 16, par exemple du tungstène.

Selon un mode de réalisation particulier de la présente invention, la nature et les épaisseurs des différentes couches sont les suivantes :
- première couche isolante 5 :
   + 5-1 : nitrure de silicium, de 20 à 300 nm, par exemple de 80 nm ;
   + 5-2 : oxyde de silicium, de 90 à 800 nm, par exemple de 400 nm ;
- largeur des premières ouvertures, remplies par le premier conducteur 6 : de 100 à 400 nm, par exemple de 240 nm ;
- premier matériau conducteur 6 : tungstène ;
- deuxième couche isolante 7 : multicouche :
   + 7-1 : oxyde de silicium, de 10 à 200 nm, par exemple de 50 nm ;
   + 7-2 : nitrure de silicium, de 10 à 100 nm, par exemple de 20 nm ;
- deuxième matériau conducteur 8 : tungstène ;
- troisième couche isolante 9 : nitrure de silicium, de 10 à 300 nm, par exemple, de 80 nm ;
- quatrième couche isolante 11 : oxyde de silicium,
   + avant gravure (et après une planarisation éventuelle), figure 3, entre 300 et 900 nm, par exemple de 600 nm ;
   + après gravure, côté mémoire, figure 5, entre 10 et 890 nm, par exemple de 400 nm ;
- largeur des troisièmes ouvertures : 50 nm ;
- distance entre deux troisièmes ouvertures : 20 nm ;
- troisième matériau conducteur 12 (premières électrodes en U des condensateurs) : silicium polycristallin, entre 30 et 300 nm, par exemple 80 nm ;
- matériau diélectrique 13 : multicouche ONO ou oxyde de tantale entre 2 et 20 nm, par exemple de 5 nm ;
- quatrième matériau conducteur 14 : silicium polycristallin, entre 100 et 800 nm, par exemple de 250 nm ;
- cinquième couche isolante 15 : oxyde de silicium, entre 50 et 500 nm, par exemple de 200 nm ; et
- cinquième matériau conducteur 16 : tungstène, de 200 à 800 nm, par exemple de 500 nm.

Selon une variante non représentée, l'épaisseur d'isolant correspondant à la couche 5-2 pourra être constituée d'une structure multicouche de matériaux gravables sélectivement l'un par rapport à l'autre. Il s'agira, par exemple, d'un multicouche oxyde de silicium - couche mince de surface de nitrure de silicium (ON), ou d'un multicouche oxyde de silicium - couche mince de nitrure de silicium - oxyde de silicium (ONO). La couche mince de nitrure de silicium constituera dans les deux cas une couche d'arrêt de gravure pour les formations ultérieures, côté mémoire, des deuxièmes ouvertures, de formation des lignes de bit, des troisièmes ouvertures, de formation des structures de condensateur, et, côté logique, des quatrièmes ouvertures, de formation des contacts. Dans le cas d'un multicouche ONO, la couche supérieure d'oxyde de silicium permet d'augmenter la capacité des condensateurs formés.

Le procédé selon l'invention qui prévoit la formation simultanée des reprises de contact avec les régions de source/drain 2, 3 des transistors de commande des cellules DRAM et avec les régions semiconductrices 4 est particulièrement simple et avantageux. En effet, d'une part, on affranchit le procédé de fabrication de contraintes de garde nécessaires dans les procédés classiques lorsque l'on voulait découvrir, côté mémoire, les régions de drain/source 3 après formation des lignes de bit. Cela permet d'obtenir des mémoires dynamiques à accès aléatoire comportant une plus grande densité de cellules mémoire.

Un autre avantage est que la formation des reprises de contact avec les régions 4 après formation des structures supérieures des cellules mémoire (condensateurs et lignes de bit) est simplifiée.

Un autre avantage est que le procédé de formation des contacts 6 entre une ligne de bit et une région de source/drain 2 devient conforme à un procédé standard CMOS comportant une couche de nitrure 5-1 à la surface du substrat. Cela simplifie le procédé en l'harmonisant des côtés logique et mémoire. En pratique, dans des procédés de fabrication simultanée de transistors MOS et de mémoire DRAM, on ne formait la couche de nitrure de silicium que du côté logique. En effet, dans les procédés classiques, on découvre côté mémoire les régions de drain/source 3 après avoir formé des structures de lignes de bit en contact avec des régions de source/drain 2. Alors, la gravure d'une couche de nitrure à la surface du substrat provoquerait la gravure des espaceurs des structures de lignes de bit. Les courts-circuits qui apparaissent alors entre les régions de drain et de source des transistors de commande des cellules DRAM par l'intermédiaire des lignes de bit et des premières électrodes des condensateurs provoquent des dysfonctionnements des cellules correspondantes. D'autre part, côté mémoire, cette couche 5-1 servant d'arrêt de gravure de la couche 5-2, les risques de gravure d'une tranchée isolante (non représentée), de même nature (oxyde de silicium) que la couche 5-2, séparant deux régions de drain ou de source de deux transistors de commande distincts sont éliminés. Les risques de dysfonctionnement par court-circuit correspondants sont donc également supprimés.

Un autre avantage est que tous les contacts, côté mémoire et côté logique, avec le substrat sont tous de même nature (conducteurs 6) au contraire de procédés classiques.

Selon un autre mode de réalisation de la présente invention, on peut avantageusement prévoir au-dessus de ceux des conducteurs 6 qui sont en contact, côté mémoire, avec les régions de source/drain 2 et, côté logique, avec les régions de source ou de drain 4 des "vignettes isolantes".

La figure 7 illustre, vues en coupe, trois parties d'une plaquette de circuits intégrés à une étape correspondant à l'étape illustrée en figure 6 obtenue selon un autre mode de mise en oeuvre. A droite de la figure, dans une première partie du substrat 1 qui correspond à la partie droite de la figure 6, on forme des cellules mémoire DRAM. A gauche de la figure, dans une deuxième partie du substrat 1 qui correspond à la partie gauche de la figure 6, on forme des dispositifs logiques. Enfin, au centre de figure, dans une troisième partie du substrat qui n'était pas représentée aux figures précédentes, on a représenté la formation, en dehors du plan mémoire, d'un contact BL avec une ligne de bit 8 d'une des cellules DRAM de la partie droite.

Comme dans le cas de la figure 1, on a procédé aux étapes suivantes : formation d'une couche isolante 5, comportant par exemple une couche 5-1 de nitrure de silicium et une couche 5-2 d'oxyde de silicium ; formation de premières ouvertures de façon à exposer partiellement les régions 2, 3 et 4 du substrat 1 ; remplissage des premières ouvertures par un premier matériau conducteur 6.

Ensuite, selon le présent mode de réalisation, on dépose une nouvelle couche isolante 17. La couche 17 pourra être une couche unique d'un matériau gravable sélectivement par rapport à la couche isolante 5-2, par exemple, du nitrure de silicium, déposé sur une épaisseur comprise entre 10 et 200 nm, par exemple 80 nm. Dans le cas d'un mode de mise en oeuvre particulier représenté en figure 7, la couche isolante 17 est un multicouche constitué d'une première couche 17-1 de même nature que la couche isolante 5-2 et une couche supérieure 17-2 d'un deuxième matériau gravable sélectivement par rapport au premier matériau constituant la couche 17-1. La couche 17-1 sera par exemple en oxyde de silicium déposé sur une épaisseur de 10 à 100 nm, par exemple 50 nm. La couche 17-2 sera par exemple en nitrure de silicium sur une épaisseur comprise entre 20 et 200 nm, par exemple 80 nm.

A l'étape suivante, la couche en le deuxième matériau isolant (couche unique 17 ou couche 17-2) est gravée, la couche sous-jacente en le premier matériau (couche 5-2 ou couche 17-1) servant d'arrêt de gravure. Cette gravure est effectuée pour laisser en place des portions de la couche (17/17-2) en le deuxième matériau isolant au-dessus des contacts avec les régions 2 et 4, formant ainsi des "vignettes isolantes" au-dessus de ces contacts.

Les étapes ultérieures du procédé sont similaires à celles décrites précédemment en relation avec les figures 3 à 6, si ce n'est que les vignettes doivent être gravées lors de la formation des deuxièmes et quatrièmes ouvertures (formation des contacts lignes de bit - régions de sources/drains 2 et formation des contacts avec les régions 4). La couche 17-1 devra également être gravée lors de la formation des troisièmes ouvertures, afin que les premières électrodes 12 des condensateurs contactent les régions de drain/source 3 par l'intermédiaire des conducteurs 6.

Un avantage de ce mode de réalisation prévoyant la formation de vignettes isolantes au moins partiellement en nitrure de silicium est que, lors de la formation des troisièmes ouvertures dans la couche isolante 11 en oxyde de silicium, la protection du contact entre la ligne de bit 8 et la région de source/drain 2 par l'intermédiaire du conducteur 6 est accrue. En effet, la gravure de ces troisièmes ouvertures sera arrêtée plus loin du conducteur 6 qu'auparavant. Les risques de surgravures conduisant à un court-circuit entre les sources/drains 2 et drains/sources 3 des transistors de commande des cellules mémoire par l'intermédiaire des premières électrodes 12 sont considérablement réduits.

Un autre avantage est donc de pouvoir s'affranchir de gardes latérales et d'augmenter encore la densité de cellules mémoire. En effet, la formation des vignettes permet de resserrer les lignes de bit.

Un autre avantage de ce mode de réalisation est lié à la formation des vignettes isolantes dans la région où doivent être formés les contacts 16/6 avec les régions de drain ou de source 4. En effet, simultanément à la formation et du remplissage des quatrièmes ouvertures, destinées à exposer les conducteurs 6 au-dessus des régions semiconductrices 4, on réalise également un contact BL avec la ligne de bit 8. Cela est représenté au centre de la figure 7. Dans la région où doit être formé le contact BL, la ligne de bit 8 est protégée par la couche 9 en le deuxième matériau isolant. En utilisant une vignette isolante constituée d'une couche 17-2 du même deuxième matériau isolant de même épaisseur que la couche 9, le procédé de formation des cinquièmes ouvertures est homogénéisé. Cela simplifie le procédé de fabrication.

On notera que les épaisseurs de la quatrième couche isolante 11 après gravure et de la cinquième couche isolante 15 sont choisies de façon à assurer un positionnement de la métallisation en contact avec une région semiconductrice 4 à une hauteur conforme aux contraintes standards de procédés CMOS.

Bien entendu, la présente invention est susceptible de diverses variantes et modifications qui apparaîtront à l'homme de l'art. En particulier, elle s'applique à tout procédé de fabrication simultanée de transistors MOS et de cellules DRAM incorporant des étapes d'un procédé CMOS standard. Ainsi, la nature et l'épaisseur de chacune des couches peuvent être modifiées en fonction des contraintes liées au procédé CMOS standard dans lequel sont incorporées les étapes propres à la formation des cellules mémoire, ou en fonction de la capacité des éléments mémoire. Ainsi, les isolants utilisés peuvent être choisis parmi les divers matériaux connus ou des combinaisons de ceux-ci, par exemple, sous forme de multicouches. De plus, bien que les matériaux des couches de remplissage des différentes ouvertures soient de préférence choisis identiques entre eux et identiques au matériau métallique (tungstène) déposé au-dessus de et latéralement par rapport à ces ouvertures (lignes de bit, métallisation 17), on peut utiliser des matériaux de remplissage différents pour chacune des différentes ouvertures et/ou différents des matériaux des couches conductrices déposées au-dessus de ces ouvertures. En outre, le dépôt d'une quelconque couche conductrice métallique peut être précédé du dépôt d'une couche d'adhérence et/ou d'arrêt de gravure.

## Revendications

1. Procédé de fabrication de cellules mémoire dynamique à accès aléatoire et de circuits logiques dans un substrat semiconducteur (1), les cellules mémoire comportant chacune un transistor MOS de commande et un condensateur, caractérisé en ce qu'il comprend les étapes suivantes :
a) former dans une première couche isolante (5) des premières ouvertures de façon à exposer partiellement des régions (2, 3) de source/drain des transistors de commande des cellules mémoire et de transistors desdits circuits logiques, et remplir les premières ouvertures d'un premier matériau conducteur (6) ;
b) déposer une deuxième couche isolante (7), former dans celle-ci, du côté des cellules mémoire, des deuxièmes ouvertures, de façon à exposer partiellement les premières ouvertures en contact avec les régions de source/drain (2) des transistors, déposer successivement un deuxième matériau conducteur (8), puis une troisième couche isolante (9), délimiter dans la troisième couche isolante et le deuxième matériau conducteur des structures de lignes de bit des cellules mémoire, et former des espaceurs latéraux (10) sur les côtés des lignes de bit ;
c) déposer une quatrième couche isolante (11) ;
d) former dans la quatrième couche isolante des troisièmes ouvertures, de façon à exposer partiellement les premières ouvertures en contact avec les régions de drain/source (3) des transistors ;
e) déposer et graver un troisième matériau conducteur (12), de façon à recouvrir les parois et le fond des troisièmes ouvertures, constituant une première électrode du condensateur ;
f) déposer de façon conforme un matériau diélectrique (13) constituant un isolant du condensateur ;
g) déposer un troisième matériau conducteur (14) constituant une deuxième électrode du condensateur ;
h) déposer un matériau diélectrique (15) ; et
i) former, du côté des circuits logiques, des quatrièmes ouvertures remplies d'un matériau conducteur (16) venant rejoindre le premier matériau conducteur (6) dans les premières ouvertures.

2. Procédé de fabrication selon la revendication 1, caractérisé en ce qu'avant l'étape b) de dépôt de la deuxième couche isolante (5) et de formation des structures de ligne de bits, sont formées des vignettes isolantes au-dessus des premières ouvertures contactant les régions de source/drain (2) des transistors de commande.

3. Procédé selon la revendication 1 ou 2, caractérisé en ce que l'étape c) de dépôt de la quatrième couche isolante (11) est effectuée de façon que sa surface supérieure soit sensiblement plane.

4. Procédé selon l'une quelconque des revendications 1 à 3, caractérisé en ce que la première couche isolante (5) est un multicouche (5-1 ; 5-2).

5. Procédé selon la revendication 4, caractérisé en ce que les couches inférieure (5-1) et supérieure (5-2) du multicouche constituant la première couche isolante (5) sont respectivement en des premier et deuxième matériaux isolants gravables sélectivement l'un par rapport à l'autre.

6. Procédé selon l'une quelconque des revendications 1 à 5, caractérisé en ce que la deuxième couche isolante (7) est un multicouche (7-1 ; 7-2).

7. Procédé selon la revendication 6, caractérisé en ce que les couches supérieure (7-2) et inférieure (7-1) du multicouche constituant la deuxième couche isolante (7) sont respectivement en des premier et deuxième matériaux isolants gravables sélectivement l'un par rapport à l'autre.

8. Procédé selon la revendication 2 et l'une quelconque des revendications 3 à 7, caractérisé en ce que les vignettes isolantes sont formées par le dépôt d'une couche (17) en un premier matériau isolant.

9. Procédé selon la revendication 2 et l'une quelconque des revendications 3 à 7, caractérisé en ce que les vignettes isolantes sont formées par le dépôt d'un multicouche (17-1, 17-2) dont la couche supérieure est en un premier matériau isolant.

10. Procédé selon la revendication 2 et l'une quelconque des revendications 3 à 9, caractérisé en ce que les vignettes isolantes sont formées simultanément au-dessus des premières ouvertures contactant les régions de source/drain (2) des transistors de commande et des premières ouvertures contactant les régions semiconductrices (4).

11. Procédé selon l'une quelconque des revendications 1 à 10, caractérisé en ce que la troisième couche isolante (9), ainsi que les espaceurs (10) sont en un premier matériau isolant.

12. Procédé selon l'une quelconque des revendications 1 à 11, caractérisé en ce que les quatrième (11) et cinquième (14) couches isolantes sont en un deuxième matériau isolant.

13. Procédé selon l'une quelconque des revendications 5 à 12, caractérisé en ce que le premier matériau isolant est du nitrure de silicium (Si₃N₄) et le deuxième matériau isolant est de l'oxyde de silicium (SiO₂).
